**Europäisches Patentamt**

**European Patent Office**

**Office européen des brevets**

(19)

(11) Veröffentlichungsnummer: **0 446 449 A2**

## (12) EUROPÄISCHE PATENTANMELDUNG

(21) Anmeldenummer: 90124153.9

(22) Anmeldetag: **13.12.90**

(51) Int. Cl.⁵: **G11C 29/00**

(30) Priorität: **15.03.90 DE 4008345**

(43) Veröffentlichungstag der Anmeldung:
**18.09.91 Patentblatt 91/38**

(84) Benannte Vertragsstaaten:
**DE FR GB NL**

(71) Anmelder: **Siemens Aktiengesellschaft**
**Wittelsbacherplatz 2**
**W-8000 München 2(DE)**

(72) Erfinder: **Ritter, Hartmut, Dipl.-Phys.**
**Sudetenweg 22**
**W-8152 Feldkirchen-Westerham(DE)**
Erfinder: **Schwair, Thomas, Dipl.-Ing.**
**Ostpreussenstrasse 10**
**W-8012 Ottobrunn(DE)**

(54) **Zum Selbsttest geeigneter Dual-Port Speicher und Verfahren zu seiner Prüfung.**

(57) Zur Durchführung eines Selbsttestes eines auf einem Chip mit anderen Einheiten angeordneten Dual-Port Speichers (CSP), der Betriebsdaten zum Betrieb der Einheiten enthält, ist der Speicher (SP) derart ausgeführt, daß der Selbsttest ohne Verlust der in dem Speicher gespeicherten Betriebsdaten durchgeführt werden kann und ohne daß diese Betriebsdaten aus dem Speicher ausgelesen werden müssen. Dazu ist der Dual-Port Speicher zwei Single-Port Speichermodulen (SPE1, SPE2) aufgebaut, die im Betrieb identischen Inhalt haben, jedoch im Testfall unterschiedlich auswählbar sind und getrennt voneinander geprüft werden können. In dem Speichermodul, die nicht getestet wird, befinden sich dann die Betriebsdaten, die nach der Prüfung des anderen Speichermoduls in diesen geschrieben werden. Der Speicher enthält weiterhin ein Signaturregister (S-RG) zur Bildung einer Signatur über die von den Speichermodulen abgegebenen Testantwortsignale und eine Vergleicherschaltung (VGL) mit der Sollsignatur.

EP 0 446 449 A2

FIG 2

Die Erfindung bezieht sich auf einen zum Selbsttest geeigneten Dual-Port Speicher, der zusammen mit anderen Einheiten auf einem Chip angeordnet ist und der mit einem ersten Datenbus und einem zweiten Datenbus verbunden ist.

Selbsttesteinrichtungen sind bekannt. Sie ermöglichen einen einfachen und vollständigen Test von auf einem Chip angeordneten Modulen oder Einheiten. Wird der Selbsttest im Systemtest eingesetzt, so werden Betriebsdaten, die in einem auf dem Chip angeordneten Speicher enthalten sind, zerstört. Häufig aber müssen diese Betriebsdaten erhalten bleiben, z.B. wenn auf dem Chip eine Verschlüsselungseinrichtung oder Kryptoeinrichtung angeordnet ist. Um die Zerstörung dieser Betriebsdaten zu vermeiden, müssen diese vor der Prüfung aus dem Chip ausgelesen und außerhalb des Chips gesichert werden. Dies ist jedoch bei Daten, die z.B. geheimbleiben sollen, unerwünscht.

Die der Erfindung zugrunde liegende Aufgabe besteht darin, die Prüfung eines auf einem Chip angeordneten Dual-Port Speichers, in dem Betriebsdaten enthalten sind, nach dem Selbsttestprinzip zu ermöglichen, ohne daß diese Betriebsdaten aus dem Chip ausgelesen werden müssen. Diese Aufgabe wird gemäß den Merkmalen des Anspruchs 1 und nach dem Verfahren gemäß Anspruch 8 gelöst.

Der für den Selbsttest geeignete Dual-Port Speicher wird mit zwei Single-Port RAM Speichereinheiten aufgebaut, die einzeln auswählbar sind. Im Betriebsmode haben diese beiden RAMs einen identischen Inhalt. Bei der Prüfung werden jedoch die beiden RAMs unabhängig voneinander und nacheinander getestet. Dabei werden die zerstörten Betriebsdaten durch Umkopieren von einem RAM zum anderen wieder zurückgewonnen. Aus diesem Grunde müssen die Betriebsdaten während des Testes weder ausgelagert noch neu geladen werden.

Um den Aufwand an zusätzlichen für den Selbsttest notwendigen Schaltungsanordnungen zu verringern, ist es zweckmäßig, zum Selbsttest das Adressenregister für den Speicher auch zur Erzeugung der Prüfsignale für die Speichereinheiten zu verwenden. Die von den Speichereinheiten daraufhin abgegebenen Testantwortsignale können auf einfache Weise in einem Signaturregister zusammengefaßt werden und dann mit einer Sollsignatur verglichen werden.

Um möglichst viele Fehlerarten feststellen zu können, ist es zweckmäßig, wenn das Adressenregister als Vorwärts-/Rückwärtszähler aufgebaut ist, so daß die aus den Adressen gewonnenen Testsignale in den einzelnen Speicherstellen in einer ersten Richtung und anschließend in der entgegengesetzten Richtung eingeschrieben werden.

Andere Weiterbildungen der Erfindung ergeben sich aus den Unteransprüchen.

Anhand eines Ausführungsbeispieles, das in den Figuren dargestellt ist, wird die Erfindung weiter erläutert. Es zeigen

Figur 1  ein Blockschaltbild eines Prozessors, der einen zum Selbsttest geeigneten Speicher enthält und der auf einem Chip angeordnet ist,

Figur 2  ein Blockschaltbild dieses Speichers,

Figur 3  die Realisierung des Adressenregisters des Speichers,

Figur 4  eine genauere Realisierung des Adressenregisters,

Figur 5  ein Schaltglied, mit dem aus den Adressen Prüfsignale gewonnen werden,

Figur 6  die Ausführung des Speichers in Speichereinheiten,

Figur 7  eine Ausführung der Testsignalauswerteschaltung,

Figur 8  eine Realisierung des Signaturregisters in der Testsignalauswerteschaltung,

Figur 9  eine Realisierung einer Steuerung, mit der der Ablauf der Prüfung gesteuert wird,

Figur 10  bis 13 ein Zeitdiagramm, das das Verhältnis der Steuersignale zueinander zeigt.

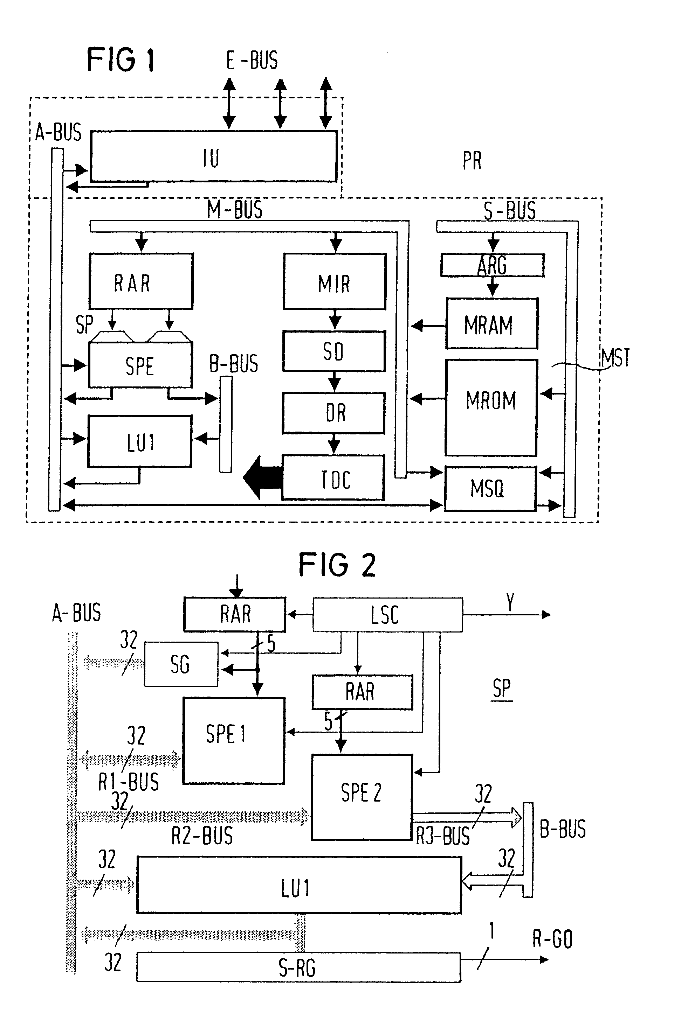

Figur 1 zeigt als Beispiel das Blockschaltbild eines auf einem Chip angeaordneten Prozessors PR, der einen Dual-Port RAM Speicher SP enthält, in dem Betriebsdaten gespeichert werden. Der Dual-Port RAM Speicher ist mit einem ersten Datenbus (A-Bus) und einem zweiten Datenbus (B-Bus) verbunden. Der Aufbau eines derartigen Prozessors ist im wesentlichen bekannt. Er enthält eine Mikroprogrammsteuerung MST, die ihrerseits ein Adressenregister ARG, ein Mikroprogramm-RAM Speicher MRAM, ein Mikroprogramm-ROM Speicher MROM und einen Sequenzer MSQ aufweist. Die Mikroprogrammsteuerung ist auf übliche Weise aufgebaut und braucht nicht weiter erläutert zu werden. Sie liefert die einzelnen Mikrobefehle, die zum Betrieb des Prozessors erforderlich sind.

Weiterhin enthält der Prozessor PR Einheiten, durch die die Mikrobefehle decodiert werden. Die Mikrobefehle werden zunächst in ein Mikrobefehlsregister MIR übertragen, gelangen von dort in einen Decoder SD, der aus den Mikrobefehlen die Steuersignale erzeugt. Diese werden in einem Decoderregister DR zwischengespeichert und dann zeitgerecht über einen Taktgeber TDC den einzelnen Einheiten des Prozessors zugeleitet.

Der Verkehr zwischen dem Prozessor PR und der Außenwelt wird über eine Schnittstelleneinheit IU durchgeführt, die an einen externen Bus E-Bus angeschlossen ist.

Zur Aufnahme der Betriebsdaten ist der Speicher SP vorgesehen, der ein Adressenregister RAR, eine Speichereinheit SPE und eine logische Einheit LU1 aufweist, in der auch eine Testauswerteschaltung angeordnet ist.

Die Verbindung zwischen der Schnittstelleneinheit IU und den einzelnen Einheiten des Prozessors PR, z.B. mit dem Speicher SP, erfolgt über den A-Bus, die Verbindungen des Speichers SP mit der Mikroprogrammsteuerung MST und den übrigen Einheiten erfolgt über einen M-Bus und die einzelnen Einheiten der Mikroprogrammsteuerung MST untereinander sind über ein S-Bus verbunden. Der E-Bus besteht aus einem Datenbus, aus einem Adreßbus und einem Steuerbus.

Beim Selbsttest des Prozessors PR muß auch der Speicher SP geprüft werden. Dazu sind im Speicher SP Selbsttesteinrichtungen zusätzlich angeordnet, über die der Selbsttest erfolgen kann. Diese Anordnungen müssen derart sein, daß die in der Speichereinheit SPE enthaltenen Betriebsdaten beim Selbsttest nicht zerstört werden und es zusätzlich nicht erforderlich ist, daß die in den Speichereinheiten SPE enthaltenen Betriebsdaten beim Selbsttest aus dem Prozessor PR ausgelesen werden müssen, z.B. zu einem externen Speicher und nach dem Selbsttest wieder geladen werden müssen. Insbesondere dann, wenn die Betriebsdaten vertrauliche Daten sind, ist es sicherer, wenn beim Test diese Betriebsdaten den Prozessor, also das Chip, nicht verlassen.

Um dies zu erreichen, ist die Dual-Pcrt Speichereinheit SPE durch zwei Single-Port RAMs SPE1 und SPE2, im folgenden Speichermodule genannt, realisiert. Der erste Speichermodul SPE1 ist über einen bidirektional Bus (R1-Bus) mit dem A-Bus verbunden, während der zweite Speichermodul SPE2 über einen unidirektionalen Bus (R2-Bus) mit dem A-Bus und einen unidirektionalen Bus (R3-Bus) mit dem B-Bus verbunden ist. Die Adresseneingänge der Speichereinheit SPE sind mit dem Adressenregister RAR verbunden, das in Figur 2 in zwei Adressenregister aufgeteilt dargestellt ist. Die für den Testbetrieb erforderlichen Testsignale werden mit Hilfe eines Schaltgliedes SG erzeugt, das aus den Adressen Testsignale erzeugt. Die Auswertung der Testantworten der Speichereinheit SPE erfolgt in einer logischen Einheit LU1, die ein Signaturregister S-RG enthält. Zur Steuerung der Abläufe wird eine Steuereinrichtung LSC verwendet.

In den Speichermodulen SPE1 und SPE2 sind im Betriebsfall identische Daten gespeichert. Diese können z.B. Zwischenergebnisse der Arbeiten des Prozessors, Schlüssel oder kundenspezifische Parameter sein.

Im Testbetrieb erfolgt die Trennung der Speichereinheit in zwei Speichermodule, die unabhängig voneinander getestet werden. Zum Beispiel kann beim Selbsttest zuerst der Speichermodul SPE1 getestet werden. Dazu erzeugt das Adressenregister RAR Adressen, die dem Adreßeingang des Speichermoduls SPE1 zugeführt wird. Diese Adressen können gleichzeitig dazu verwendet werden, um die Testsignale für den Speichermodul SPE1 zu erzeugen. Deswegen werden die Adressensignale über das Schaltglied SG dem A-Bus zugeleitet und gelangen von dort zum Datenanschluß des Speichermoduls SPE1. Die daraufhin vom Speichermodul SPE1 abgegebenen Testantwortsignale werden wiederum über den A-Bus zur logischen Einheit LU1 übertragen und dort in einem Signaturregister S-RG gesammelt. Nach Abschluß des Testens des Speichermoduls SPE1 wird die Signatur mit einer Sollsignatur verglichen und daraus abgeleitet, ob ein Fehler aufgetreten ist oder nicht.

Nach Abschluß der Prüfung des Speichermoduls SPE1 wird der Inhalt des Speichermoduls SPE2 in den Speichermodul SPE1 übertragen. Dies sind die in dem Speichermodul SPE2 enthaltenen Betriebsdaten. Jetzt kann entsprechend der Prüfung des Speichermoduls SPE1 auch der Speichermodul SPE2 getestet werden. Dem Speichermodul SPE2 werden wiederum Adreßsignale zugeführt und aus den Adreßsignalen Prüfsignale erzeugt, die über den A-Bus dem Speichermodul am Dateneingang zugeleitet werden. Die in dem Speichermodul SPE2 geladenen Prüfsignale werden wieder ausgelesen und über den B-Bus in die logische Einheit LU1 übertragen und dort in Signaturregister S-RG gesammelt. Am Schluß der Prüfung wird die Signatur mit einer Sollsignatur verglichen und die Fehlerfreiheit überprüft.

Der Speicher SP ist so ausgeführt, daß dieselben Prüfsignale in dieselben Speicherstellen der Speichermodule SPE1 und SPE2 eingeschrieben werden; damit ist für beide Speichermodule die Sollsignatur identisch. Die Sollsignatur kann bereits im Signaturregister S-RG, z.B. fest verdrahtet, enthalten sein. Wichtig ist, daß der jeweilige Inhalt eines zu prüfenden Speichermoduls in dem anderen Speichermodul enthalten ist und nach der Prüfung zurückgeschrieben wird. Damit ist sichergestellt, daß die Betriebsdaten beim Selbsttest nicht verloren gehen.

Ein vorteilhafter Algorithmus zur Erzeugung der Prüfsignale besteht darin, daß die aktuelle Adresse, die der Speichereinheit SPE zugeführt wird, auch dazu verwendet wird, um die Prüfsignale zu erzeugen, die in die adressierte Speicherstelle der Speichereinheit eingeschrieben werden. Das heißt, die aktuelle Adresse ist gleichzeitig auch Prüfsignal. Um möglichst viele Fehlerarten feststellen zu können, ist es dabei zweckmäßig in folgender Weise die Adressen an die Speichereinheit anzulegen und die daraus abgeleiteten Prüfsignale einzuspeichern bzw. die eingespeicherten Prüfsignale wieder zu lesen:

Das Adressenregister RAR, das als Vorwärts/Rückwärtszähler realisiert ist, wird zunächst auf 0 zurückgesetzt. Anschliessend wird folgendermaßen vorgegangen unter der Voraussetzung, daß es n Speicherstellen gibt, die geprüft werden müssen, i eine laufende Variable ist:

1. for i = 0 to n - 1 do W(A)
2. for i = 0 to n - 1 do R(A)/W(-A)
3. for i = 0 to n - 1 do R(-A)/W(A)
4. for i = n - 1 to 0 do R(A)
5. for i = n - 1 to 0 do R(A)/W(A)
6. for i = n - 1 to 0 do R(A)/W(-A)
7. for i = n - 1 to 0 do R(-A)/W(A)

Dabei bedeutet W(A) das Beschreiben der mit A adressierten Speicherstelle mit dem Wert der erweiterten Adresse A, W(-A) das Beschreiben der mit A adressierten Speicherstelle mit der invertierten Adresse A. Entsprechend ist R(A) Lesen der mit A adressierten Speicherstelle in der Erwartung, daß die erweiterte Adresse A ausgelesen wird, bzw. R(-A) Lesen der mit A adressierten Speicherstelle mit der Erwartung, daß die erwartete invertierte Adresse ausgelesen wird. Der Algorithmus ist aus M. Marinescu, "Simple and Efficient Algorithms for Functional RAM Testung", IEEE Test Conference 1982, S. 236-239, bekannt.

Mit diesem Testalgorithmus werden alle Stuck-at Fehler in den Speicherelementen und alle Stuck-at Fehler im Adreßdecoder entdeckt. Zusätzlich lassen sich alle einseitigen und damit auch zweiseitigen Koppelfehler auf den Adreßleitungen erkennen. Überbrückungsfehler auf den Datenbussen können ebenfalls weitgehend festgestellt werden.

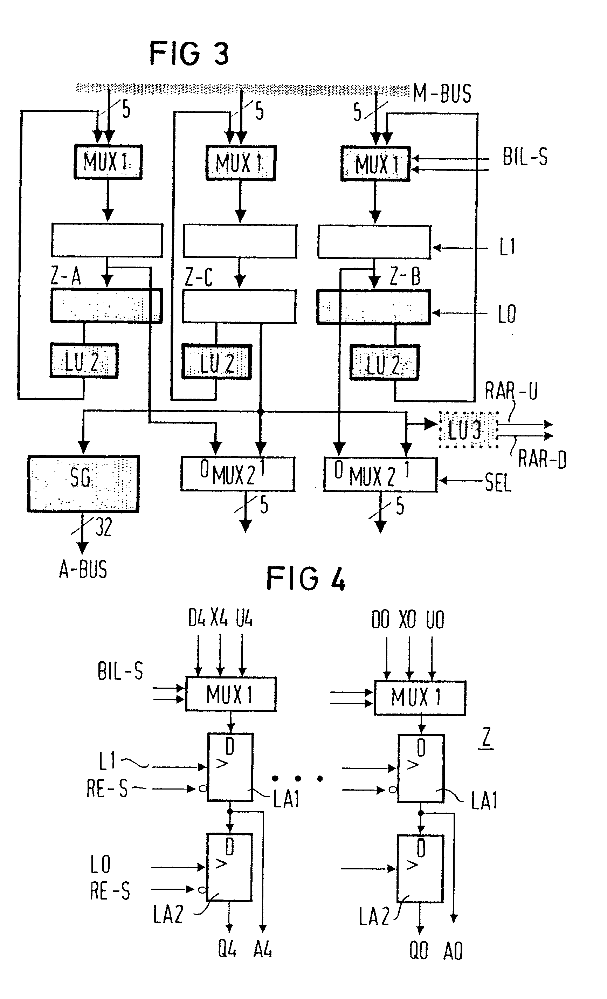

Das Adressenregister RAR muß zur Ausführung dieses Testalgorithmus als Vorwärts/Rückwärts Zähler aufgebaut sein. Ein mögliches Ausführungsbeispiel zeigt Figur 3. In diesem Ausführungsbeispiel ist das Adressenregister mit Hilfe von drei Vorwärts/Rückwärtszählern Z-A, Z-B, Z-C realisiert. Es ist selbstverständlich auch möglich, weniger Zähler zu verwenden. Mit Hilfe eines derart ausgeführten Adressenregisters RAR ist es möglich, die Speichermodule SPE1 und SPE2 mit einem einzigen Vorwärts/Rückwärtszähler anzusteuern, z.B. mit dem Vorwärts/Rückwärtszähler Z-C, es ist aber auch möglich, die Speichermodule SPE1, SPE2 getrennt anzusteuern, und zwar mit Hilfe des Zählers Z-A den Speichermodul SPE1 und mit Hilfe des Zählers Z-B den Speichermodul SPE2. Im Testbetrieb kann im Ausführungsbeispiel der Zähler Z-C verwendet werden, dessen Adreßsignale dem Speichermodul SPE1 bzw. dem Speichermodul SPE2 zugeführt werden und aus denen die Testsignale gewonnen werden. Dementsprechend werden die Ausgänge der Zähler Z über Multiplexer MUX2 entsprechend der mit Hilfe eines Auswahlsignales SEL gewählten Betriebsart an die entsprechenden Speichereinheiten angeschlossen.

Das Adressenregister RAR ist als BILBO-Register so ausgeführt, daß es unterschiedliche Betriebsarten als Register, Zähler, Signaturregister durchführen kann. Es kann als normales Adressenregister arbeiten, dem über den M-Bus die Adressensignale zugeführt werden, die dann in die Zähler Z eingespeichert werden und von dort unverändert der Speichereinheit zugeführt werden. In diesem Falle arbeiten die Zähler Z nicht als Zähler, sondern als Register. Es ist jedoch auch möglich, die Zähler Z so zu schalten, daß sie als Zähler arbeiten. Dazu wird der Ausgang des Zählers über eine logische Einheit LU2 mit dem Eingang verbunden, also eine Rückkopplung hergestellt. Die Rückkopplung über die logische Einheit LU2 kann derart sein, daß unterschiedliche Zählfolgen erzeugt werden. Die Rückkopplung erfolgt über einen Multiplexer MUX1, der von Auswahlsignalen BIL-S angesteuert wird. Über zwei Auswahlsignale können dem Zähler vier verschiedene Betriebsarten gegeben werden, von denen für den Test des Speichers nur zwei interessant sind. Die Zähltakte für die Zähler werden als Taktsignale L1, L0 zugeführt. Dies deswegen, weil jede Zählstelle aus zwei Latchstufen LA1, LA2 besteht, die nacheinander getaktet werden. Selbstverständlich ist es auch möglich, jede Zählstelle als Flip-Flop zu realisieren, so daß nur ein einziger Zähltakt erforderlich wäre. Immer dann, wenn ein Zähler eine gewählte Zählfolge durchlaufen hat, gibt eine logische Einheit LU3 ein Signal RAR-U oder RAR-D ab. RAR-U wird dann gegeben, wenn der Zähler abwärtsgezählt hat, RAR-D, wenn er aufwärtsgezählt hat.

Eine genauere Realisierung der Zähler Z ist in Figur 4 gezeigt. Es sind lediglich die Zählstellen angegeben, z.B. für vier Zählstellen. Dem Multiplexer MUX1 werden entweder die Adreßsignale vom M-Bus als X-Signale zugeleitet oder die über die logische Einheit LU2 rückgekoppelten Signale U oder D. Die Latchstufen LA1, LA2 werden zunächst mit einem Reset Signal RE-S zurückgesetzt. Anschließend werden die Signale X, U oder D über den Multiplexer MUX1 zugeleitet und mit Hilfe des Taktsignals L1 in die Latchstufe LA1 übernommen. Die Übergabe zu LA2 erfolgt mit dem Taktsignal L0. Von der Latchstufe LA1 wird das Adressensignal A abgenommen, während von der Latchstufe LA2 das rückzukoppelnde Signal Q abgenommen wird.

Die Ausführung der logischen Einheit LU2, die in der Rückkopplungs liegt, ist derart, daß die folgenden Gleichungen erfüllt sind:
Beim Aufwärtszählen gilt:

$U_0$: = EXOR ($Q_2$,EXOR ($Q_4$,NOR ($Q_3$, $Q_2$, $Q_1$, $Q_0$)-) )

$U_1$: = $Q_0$

$U_2$: = $Q_1$

$U_3$: = $Q_2$

$U_4$: = $Q_3$

Beim Abwärtszählen gilt:

$D_0$ : = $Q_1$

$D_1$: = $Q_2$

$D_2$: = $Q_3$

$D_3$: = $Q_4$

$D_4$: = EXOR ($Q_3$,EXOR($Q_0$,NOR($Q_4$,$Q_3$,$Q_2$,$Q_1$)))

Die Endesignale für das Aufwärtszählen bzw. Abwärtszählen werden nach folgenden Gleichungen erzeugt, und zwar durch die logische Einheit LU3:

RAR-U: = AND ($Q_4$,NOR ($Q_3$,$Q_2$,$Q_1$,$Q_0$))

RAR-D: = AND ($Q_0$, NOR ($Q_4$,$Q_3$,$Q_2$,$Q_1$,))

Aus den Adreß-Signalen A werden beim Prüfen auch die Prüfsignale T-S erzeugt. Dies erfolgt mit Hilfe des Schaltgliedes SG, das im Ausführungsbeispiel aus z.B. fünf Adreß-Signalbit 32 Prüfsignalbit durch Aufdoppeln bildet. Dazu werden die Adreß-Signale EXOR-Schaltungen EX1 zugeleitet, die zusätzlich von einem Steuersignal EX1-S angesteuert werden. Die von den EXOR Schaltungen EX1 abgegebenen Prüfsignale werden dann über eine Treiberstufe TR1 dem A-Bus zugeleitet. Die Treiberstufe TR1 wird durch ein Steuersignal TR1-S angesteuert. Mit Hilfe der EXOR-Schaltungen EX1 können die Adreß-Signale entweder unbeeinflußt oder invertiert als Prüfsignale dem A-Bus zugeleitet werden.

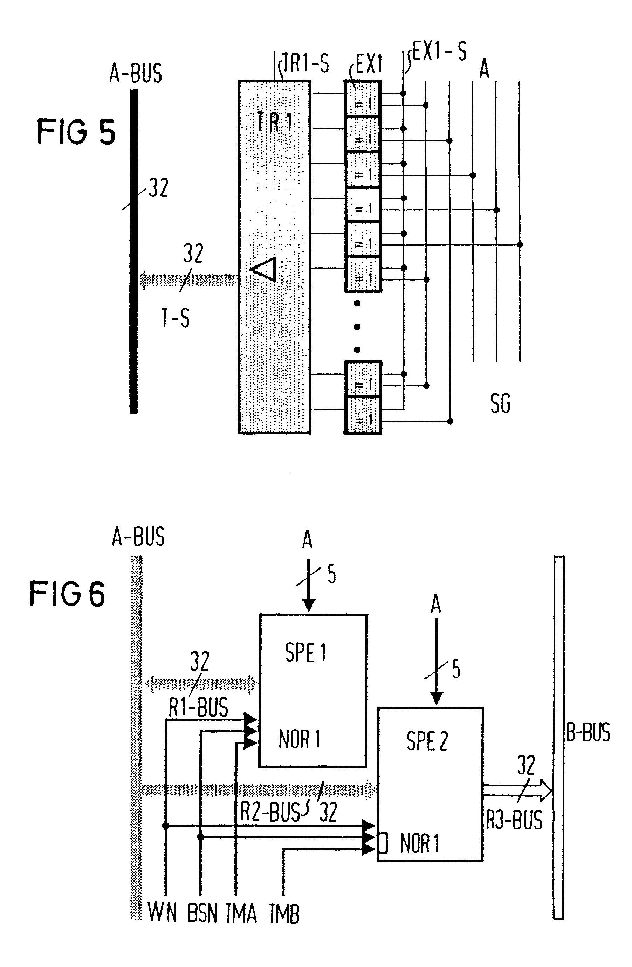

Die nähere Ausführung der Speichereinheit SPE kann Figur 6 entnommen werden. Die Speichermodule SPE1 und SPE2 sind als Single-Port RAM's realisiert, von denen SPE1 mit dem A-Bus, SPE2 mit dem A-Bus und dem B-Bus verbunden sind. Den Adreß-Eingängen werden Adreß-Signale A zugeleitet, die vom Adressenregister RAR erzeugt werden. Um die Speichermodule SPE1, SPE2 in die verschiedenen Betriebszustände schalten zu können, ist ein Signal BSN vorgesehen, durch das die Speichereinmodule SPE1 und SPE2 aktiviert werden. Zur getrennten Auswahl der Speichermodule werden Steuersignale TMA und TMB verwendet, wobei das Steuersignal TMA nur dem Speichermodul SPE1 und das Steuersignal TMB nur dem Speichermodul SPE2 zugeführt wird. Durch NOR-Verknüpfung (NOR 1) der Signale BSN und TMA bzw. BSN und TMB ist dann die getrennte Auswahl der Speichermodule sichergestellt. Das Signal WN gibt an, ob in die Speichermodule geschrieben oder aus ihnen gelesen wird. Im Ausführungsbeispiel beträgt die Breite der Adressen 5 bit, während die Breite der Daten 32 bit beträgt.

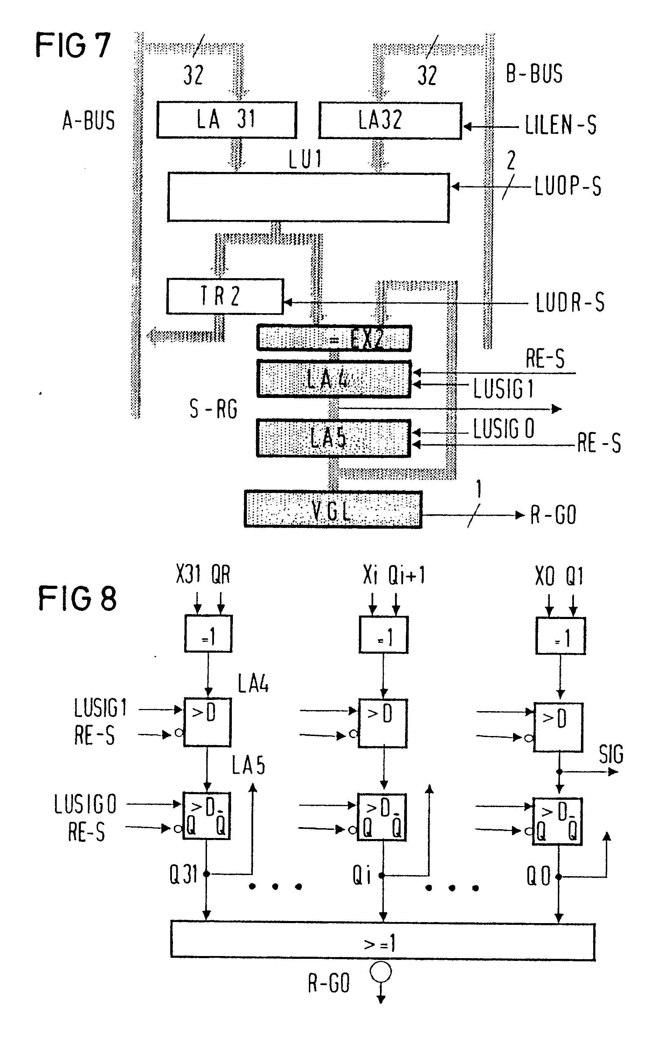

Die logische Einheit LU1, die Gegenstand der Figur 7 ist, enthält eine Latchstufe LA31 bzw. LA32 zur Zwischenspeicherung von Daten vom A-Bus bzw. B-Bus, einen Treiber TR2 und die Testsignalauswerteschaltung, bestehend aus einem Signaturregister S-RG, das auch einen Vergleicher VGL enthält. Über den Treiber TR2 ist es möglich, Daten wieder auf den A-Bus zurückzuleiten, dazu wird er von einem Steuersignal LUDR-S angesteuert.

Die Latchstufen LA31, LA32 erhalten ein Enable-Signal LUEN-S. Die logische Einheit LU1 wird von einem Steuersignal LUOP-S angesteuert und schaltet im Testbetrieb entweder den Ausgang der Latchstufe LA31 oder LA32 zum Ausgang durch. Demzufolge können die von dem Speichermodul SPE 2 über den B-Bus abgegebenen Daten auf den A-Bus übertragen werden und von dort in den Speichermodul SPE1 geladen werden. Oder die vom B-Bus bzw. A-Bus kommenden Testantwortsignale können der Testsignalauswerteschaltung zugeleitet werden.

Für den Selbsttest wichtiger ist die Ausführung des Signaturregisters S-RG mit Vergleicher VGL. Das Signaturregister S-RG ist aus einem EXOR-Glied EX2 und zwei Latchstufen LA4 und LA5 aufgebaut. An die Stelle der Latchstufen LA4 und LA5 kann auch ein Flip-Flop treten. Die Latchstufen LA4 und LA5 werden mit Hilfe eines Rücksetzsignales RE-S zurückgesetzt und mit Hilfe von Taktsignalen LUSIG1 und LUSIG0 getaktet. Zur Bildung der Signatur ist eine Rückkopplung vom Ausgang zum Eingang vorgesehen. Die Vergleichsschaltung VGL besteht aus einem NOR-Glied, in dem die Sollsignatur fest verdrahtet vorliegt.

Die genauere Ausführung des Signaturregisters S-RG kann Figur 8 entnommen werden. Das Signaturregister hat im Ausführungsbeispiel 32 Stufen entsprechend den 32 bit der Speicherstellen der Speichereinheiten. Der Aufbau kann Figur 8 entnommen werden.

Der Rückkopplungsterm lautet z.B.

OR = EXOR $Q_0$(ExOR($Q_1$EXOR($Q_2$,$Q_{22}$))).

Die Ausgänge Q bzw. $\overline{Q}$ werden der Vergleichsschaltung VGL zugeführt, die diese Ausgänge mit der Sollsignatur vergleicht. Bei Gleichheit gibt die Vergleichsschaltung dann das Signal R-GO ab. Über den Ausgang SIG ist es auch möglich, die Signatur auszulesen.

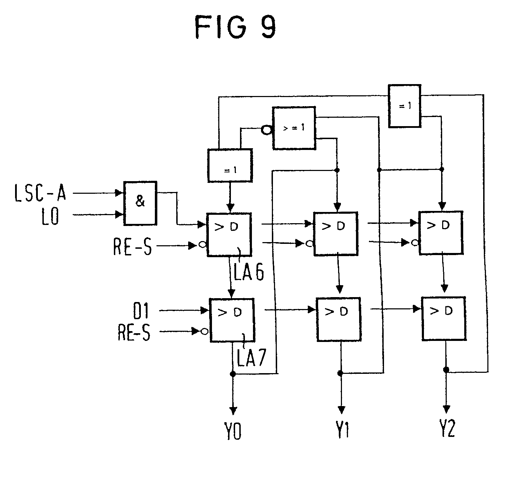

Der Speichertest-Algorithmus wird über die Steuerschaltung LSC gesteuert. Eine Ausführung der Steuerschaltung zeigt Figur 9. Sie besteht aus Latchstufen LA6, LA7, die entsprechend Figur 9 zusammengeschaltet sind. Den Latchstufen LA werden Rücksetzsignale RE-S zugeführt, um diese in eine Ausgangsstellung zu bringen. Als Zähltakte werden die Signale L0 und D1 verwendet. Das Signal LSC-A wird durch eine ODER-Verknüpfung der Signale RAR-U und RAR-D gewonnen. Das heißt, der Zustand der Steuerschaltung LSC hängt vom Zählerstand des Vor- und Rückwärtszählers ab, der die Adressen im Testbetrieb erzeugt. Dies ist im Ausführungsbeispiel der Zähler Z-C. Mit Beginn des Testbetriebes wird der Steuerschaltung ein Selbsttestbefehl zugeführt, der LSC einschaltet.

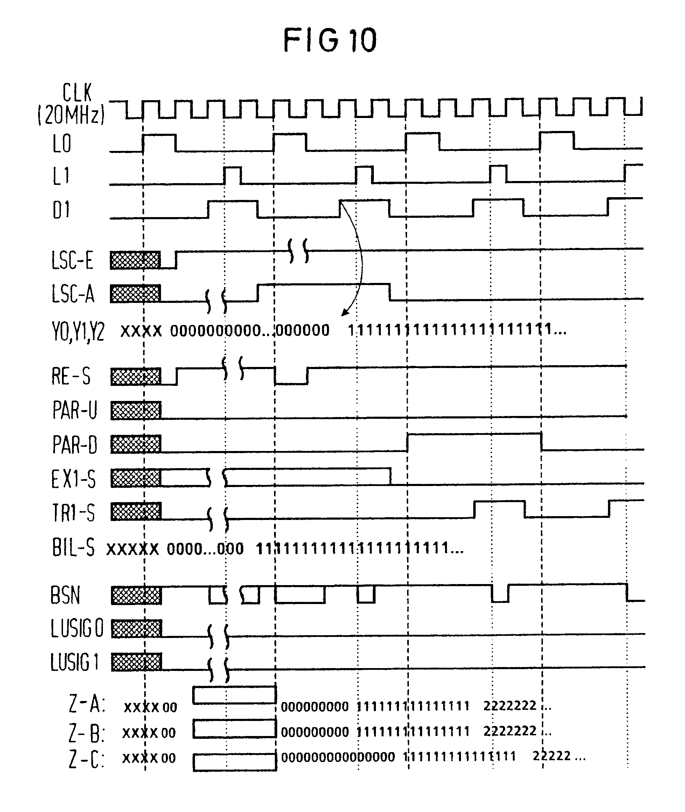

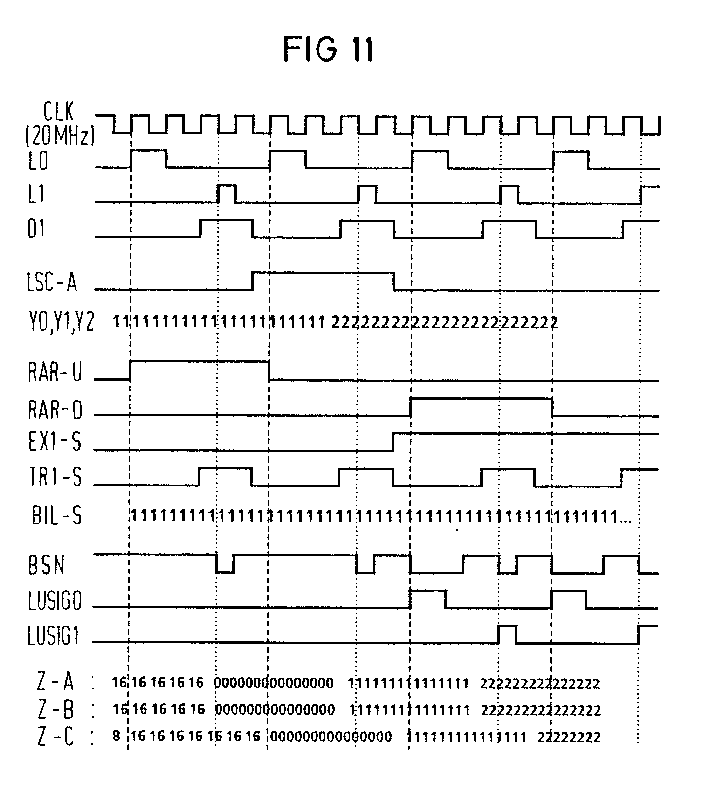

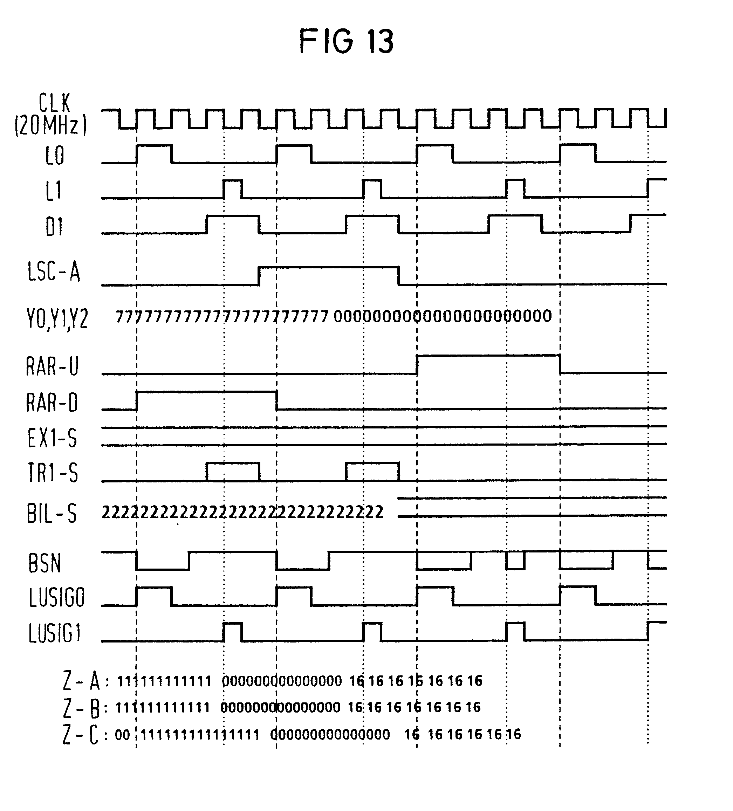

Anhand des Taktdiagrammes, das in Figuren 10 bis 13 dargestellt ist, kann die Arbeitsweise der Steuerschaltung erkannt werden und festgestellt werden, wann dessen Ausgangssignale YO, Y1 und Y2 auftreten. Mit Hilfe des Taktdiagramms der Figur 10 bis 13 und der Realisierung der Figur 9 ist es ohne weiteres möglich, den Zeitpunkt des Auftretens der Steuersignale für die einzelnen Einheiten des Speichers abzuleiten.

Zunächst wird die Steuerschaltung LSC in einen Wartezustand überführt, dies geschieht mit Hilfe der Reset-Signale RE-S. Die Steuerschaltung wird aktiv, wenn das Signal LSC-A erscheint. Mit den darauf folgenden Signalen L0 und D1 werden die für den Test notwendigen Signale Y0, Y1, Y2 erzeugt.

Wie aus Figur 10 erkennbar ist, wechselt dann die Steuerschaltung LSC in den Zustand 1. Ab diesem Zeitpunkt übernimmt die Steuerschaltung LSC die Kontrolle über BSN und WN, über BIL-S, TRI-S sowie LUSIG0 und LUSIG1. In der Schreibphase wird das Schaltglied SG aktiviert und die von den Adressen abgeleiteten Prüfsignale in die Speichereinheiten geschrieben. Das Signaturregister S-RAG bleibt noch inaktiv. Der Stand des Adressenregisters RAR kann ebenfalls der Figur 10 entnommen werden.

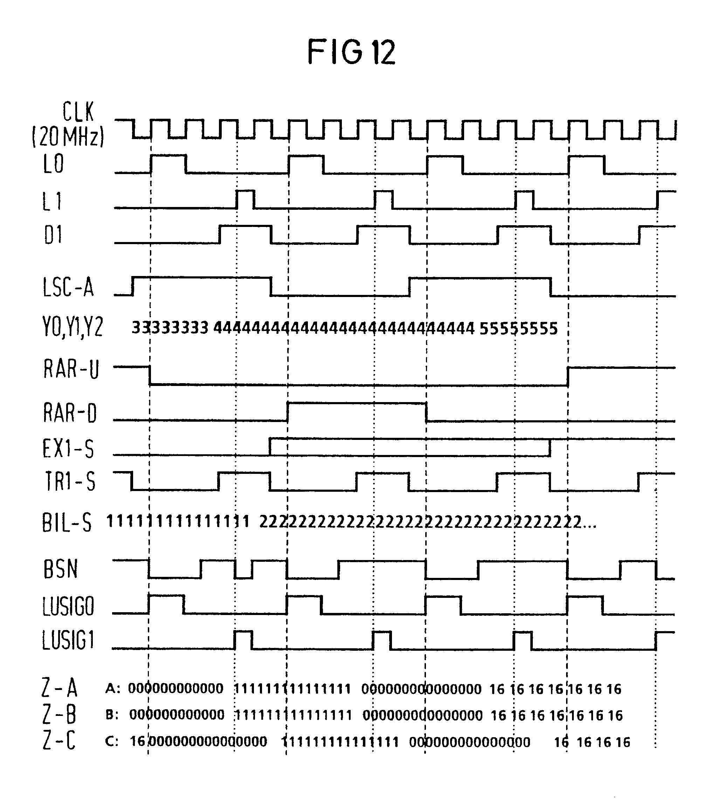

Bei LSC Zustand 1 oder in der Phase 1 werden unter allen Adressen der Speichereinheiten Daten, also Prüfsignale, geschrieben. Sobald alle Adressen durchgezählt sind, gibt das Adressenregister das Signal RAR-U ab und damit geht LSC in die Phase 2. In der Phase 2 werden Daten aus der Speichereinheit SPE ausgelesen und anschließend dazu invertierte Adressensignale als Prüfsignal eingeschrieben. Ab diesem Zeitpunkt wird auch das Signaturregister S-RG aktiv, da nun in den Lesephasen Testantwortsignale anliegen. Ab Phase 4 wird der Vorwärts-/Rückwärtszähler Z auf Rückwärtszählung umgeschaltet (Figur 12). In der Phase 4 werden nur zwei Adressen gelesen, da durch die Änderung der Laufrichtung sofort das Signal RAR-D folgt. Diese Phase dient deshalb nur zur Synchronisation. Die Daten können dabei auch invertiert auf den A-Bus geschrieben werden, da die Speichereinheiten während der Schreibphasen inaktiv sind. Das Signaturregister dagegen bleibt aktiv. In der Phase 5 hingegen müssen die Daten invertiert angelegt werden (Figur 12).

Wenn sich die Steuerschaltung LSC im Zustand 7 befindet, sendet der Zähler Z-C das Endesignal RAR-D. Die Steuerschaltung geht wieder in den Zustand 0 über und der Testvorgang ist beendet. Die Änderung des Zustandes der Steuerschaltung LSC erfolgt nach Start mit Selbsttestbefehl über die Endekriterien RAR-U und RAR-D, die von dem Zähler abgeleitet werden.

Die von der Steuerschaltung LSC abgegebenen Signale Y werden z.B. über den M-Bus auch dem Decoder SD zugeführt, der sie in Steuersignale umwandelt, die dann zeitrichtig von dem Zeitdecoder TDC den einzelnen Einheiten des Speichers SP zugeführt wird. Die Umwandlung in Steuersignale erfolgt mikroprogrammiert und ist bei Kenntnis der Ablaufdiagramme der Figuren 10 bis 13 leicht ausführbar.

Der Selbsttest des Speichers SP ist in Verbindung mit dem Prozessor PR beschrieben worden. Selbstverständlich kann der Speicher SP auch mit anderen Einheiten zusammenarbeiten. Dies ist in allen Anwendungen sinnvoll, in denen Dual-Port RAM einem Selbsttest unterworfen wird und die Betriebsdaten erhalten bleiben müssen.

## Patentansprüche

1. Zum Selbsttest geeigneter Dual-Port Speicher (SP), der zusammen mit anderen Einheiten auf einem Chip angeordnet ist und der mit einem ersten Datenbus (A-Bus) und einem zweiten Datenbus (B-Bus) verbunden ist, mit folgenden Merkmalen:

   a) es ist ein erster als Single-Port RAM realisierter einzeln auswählbarer Speichermodul (SPE1) vorgesehen, dessen Adreßeingänge mit einem als Zähler (Z) realisierten Adreßregister (RAR) verbunden ist und dessen Dateneingang über einen bidirektionalen Bus (R1-Bus) mit dem ersten Datenbus (A-Bus) verbunden ist,

   b) es ist eine zweiter als Single-Port RAM realisierter einzeln auswählbarer Speichermodul (SPE2) vorgesehen, dessen Adreßeingänge mit einem als Zähler ausgeführten Adreßregister (RAR) verbunden ist und dessen Dateneingang über einen ersten unidirektionalen Bus (R2-Bus) mit dem ersten Datenbus (A-Bus) und dessen Datenausgang über einen zweiten unidirektionalen Bus mit dem zweiten Datenbus (B-Bus) verbunden ist,

   c) es ist ein Schaltglied (SG) vorgesehen, das das Adressenregister (RAR) mit dem ersten Datenbus (A-Bus) im Testbetrieb verbindet,

   d) es ist eine Testsignalauswerteschaltung (LU1) vorgesehen, die mit den Datenbussen (A-Bus, B-Bus) zur Übernahme von Testantwortsignalen von den Speichermodulen (SPE1, SPE2) verbunden ist.

2. Speicher nach Anspruch 1,

dadurch **gekennzeichnet,**
daß das Adressenregister als Vorwärts/Rückwärtszähler ausgebildet ist.

3. Speicher nach Anspruch 2, dadurch **gekennzeichnet,** daß der Zähler nach dem Bilboprinzip realisiert ist und neben Vorwärts/Rückwärtszählung auch als normales Register und als Signaturregister schaltbar ist.

4. Speicher nach einem der Ansprüche 1 bis 3, dadurch **gekennzeichnet,** daß das Schaltglied (SG) so ausgeführt ist, daß es die zugeführten Adressen unverändert oder invertiert auf den Datenbus (A-Bus) schaltet.

5. Speicher nach Anspruch 4, dadurch **gekennzeichnet,** daß das Schaltglied (SG) aus den zugeführten Adressen (A) Testsignale (T-S) erzeugt, deren Bitanzahl größer ist als die Bitanzahl der Adressen.

6. Speicher nach einem der vorhergehenden Ansprüche, dadurch **gekennzeichnet,** daß die Testauswerteschaltung (LU1) aus einem Signaturregister (S-RG) und einem die Sollsignatur enthaltenden Vergleicher (VGL) besteht.

7. Speicher nach Anspruch 6, dadurch **gekennzeichnet,** daß der Vergleicher (VGL) als NOR-Glied realisiert ist, in dem die Sollsignatur fest verdrahtet ist.

8. Verfahren zur Prüfung eines Speichers (SP) gemäß Anspruch 1 mit folgenden Merkmalen:
   a) die Prüfung der Speichermodule (SPE1, SPE2) wird nacheinander durchgeführt,
   b) die Speichermodule enthalten dieselben Betriebsdaten,
   c) die Prüfung der Speichermodule (SPE1, SPE2) wird mit folgenden Schritten durchgeführt:
   c1) das Adreßregister (RAR) erzeugt Adressen zur Auswahl der Speicherstellen des Speichermoduls (SPE1 bzw. SPE2),
   c2) die vom Adressenregister (RAR) abgegebenen Adressen werden dem Schaltglied (SG) zugeführt, das aus den Adressen Testsignale (T-S) erzeugt, die dem ersten Datenbus (A-Bus) zugeführt werden,
   c3) vom ersten Datenbus (A-Bus) gelangen die Testsignale zu dem Speichermodul (SPE1 bzw. SPE2) und werden dort in die adressierten Speicherstellen eingeschrieben,
   c4) die in dem Speichermodul (SPA1 bzw. SPE2) gespeicherten Testsignale werden als Testantwortsignale ausgelesen und über den ersten Datenbus (A-Bus) bzw. zweiten Datenbus (B-Bus) der Testauswserteschaltung (LU1) zugeführt,
   c5) die Testauswerteschaltung bildet von den Testantwortsignalen eine Signatur, die mit einer Sollsignatur verglichen wird, c6) der Inhalt des nicht getesteten Speichermoduls wird in den getesteten Speichermodul geladen.

9. Verfahren nach Anspruch 8, dadurch **gekennzeichnet,** daß der zur Prüfung verwendete Algorithmus darin besteht, daß zunächst in aufsteigender Zählung Adressen erzeugt werden und die Adressen in die adressierten Speicherstellen eingeschrieben werden, anschließend die eingeschriebene Adressen ausgelesen werden und gleichzeitig die Adressen invertiert eingeschrieben werden, dann die invertierten Adressen gelesen werden und dann in umgekehrter Richtung die Speicherstellen adressiert werden und die Adressen eingeschrieben und anschließend gelesen werden.

## FIG 1

E -BUS

A-BUS

IU

PR

M-BUS

S-BUS

RAR

MIR

ARG

SP

SPE

B-BUS

SD

MRAM

MST

DR

MROM

LU1

TDC

MSQ

## FIG 2

A-BUS

RAR

LSC

Y

32

SG

5

32

SPE 1

RAR

SP

5

R1-BUS

32

32

SPE 2

32

R2-BUS

R3-BUS

B-BUS

32

32

32

LU1

32

1

R-GO

32

S-RG

# FIG 3

# FIG 4

FIG 5

FIG 6

**FIG 7**

**FIG 8**

# FIG 9

# FIG 10

# FIG 11

# FIG 12

CLK (20 MHz)
LO
L1
D1
LSC-A
YO,Y1,Y2    33333333 4444444444444444444444444444 55555555
RAR-U
RAR-D
EX1-S
TR1-S
BIL-S  11111111111111 222222222222222222222222222222222...
BSN
LUSIGO
LUSIG1

Z-A  A: 000000000000 111111111111111 000000000000000 16 16 16 16 16 16 16
Z-B  B: 000000000000 111111111111111 000000000000000 16 16 16 16 16 16 16
Z-C  C: 16 000000000000000 111111111111111 000000000000000   16 16 16 16

# FIG 13